# EUROPÄISCHE PATENTSCHRIFT

(11) **EP 1 383 360 B1**
(45) Veröffentlichungstag und Bekanntmachung des Hinweises auf die Patenterteilung: **03.01.2007**
(21) Anmeldenummer: 02015961.2
(22) Anmeldetag: 18.07.2002
(51) Int. Cl.: H05K 1/00, H05K 3/00, H05K 3/18

(54) **Spritzgegossener Leiterträger und Verfahren zu seiner Herstellung**
Injection moulded lead carrier and method of producing the same
Support de circuit imprimé moulé par injection et son procédé de fabrication

(43) Veröffentlichungstag der Anmeldung: 21.01.2004
(73) Patentinhaber: Festo AG & Co., 73734 Esslingen (DE)
(72) Erfinder: Schauz, Stephan, 73312 Geislingen/Steige (DE)
(74) Vertreter: Abel, Martin

(56) Entgegenhaltungen:
- WO-A-01/97583
- DE-A- 19 921 660
- M. HÜSKE, J. KICKELHAIN, J. MÜLLER, G. ESSER: "Laser supported activation and additive metallization of thermoplastics for 3D-MIDS" PROCEEDINGS OF THE 3RD LANE 2001, [Online] 28. - 31. März 2001, XP002242586 Erlangen, Germany Gefunden im Internet: <URL:www.lpkfusa.com/articles/hdi/laser_ac tivation.pdf > [gefunden am 2003-05-19]
- PATENT ABSTRACTS OF JAPAN vol. 018, no. 447 (E-1594), 19. August 1994 (1994-08-19) -& JP 06 140734 A (HITACHI CABLE LTD), 20. Mai 1994 (1994-05-20)

## Beschreibung

Die Erfindung betrifft einen unter Anwendung eines 2-Komponenten-Spritzgießverfahrens in sogenannter MID-Technologie (MID = Moulded Interconnect Device) hergestellten Leiterträger und ein besonders ausgestaltetes Herstellungsverfahren gemäß den Oberbegriffen der Patentansprüche 1 und 6.

In sogenannter MID-Technologie (MID = Moulded Interconnect Device) gefertigte spritzgegossene Leiterträger finden vermehrt Verbreitung, weil sie, anders als konventionelle Leiterplatten, die Realisierung komplexer, dreidimensionaler Leiterstrukturen ermöglichen. Die EP 0782765 B1 beschreibt mögliche Aufbauten und Strukturen solcher Leiterträger, wobei ein aus thermoplastischem Kunststoffmaterial bestehendes Trägersubstrat als Spritzgussteil zugrunde gelegt wird, an dessen Oberfläche dem gewünschten Verlauf entsprechende Leiterbahnen ausgebildet werden. Die Leiterbahnen sind hier das Ergebnis einer Laserstrukturierung des zuvor ganzflächig metallisierten Trägersubstrates.

Ein ebenfalls häufig zur Anwendung gelangendes Spritzgießverfahren ist der sogenannte 2-Komponenten-Spritzguss. Hier wird aus einem grundsätzlich galvanisch metallisierbaren ersten Kunststoffmaterial ein erstes Trägersubstrat spritzgegossen, an das unter Verwendung einer entsprechend gestalteten Spritzgießform ein aus einem grundsätzlich nicht metallisierbaren zweiten Kunststoffmaterial bestehendes zweites Trägersubstrat angeformt wird, wobei vorbestimmte Bereiche des ersten Trägersubstrates nicht bedeckt werden. In einem sich anschließenden Galvanisierungsprozess wird auf den unabgedeckten Bereich des ersten Trägersubstrates eine als Leiteranordnung fungierende Metallisierung abgeschieden.

Aus der DE 199 21 660 A geht eine Mikroventilanordnung hervor, die ein zumindest teilweise als Leiterträger der eingangs genannten Art ausgebildetes und nach dem eingangs erwähnten Verfahren herstellbares Gehäuse aufweist. Das Gehäuse ist als MID-Körper ausgeführt und unmittelbar mit einer Leiterstruktur versehen.

Neuerdings kommt auch eine MID-Technologie mit einer Laser-Direkt-Strukturierung zum Einsatz. Bei diesem, beispielsweise in der Zeitschrift "PLASTVERARBEITER", 52. Jahrgang (2001), Nr. 11, Seite 92, angesprochenen Verfahren wird das Schaltungs-Layout auf einem Hochleistungskunststoff (beispielsweise sogenanntes PBTMID, PA6/6TMID) erzeugt, indem mit einem dem gewünschten Leiterbahnverlauf folgenden Laserstrahl bestimmte Oberflächenbereiche des von Hause aus nicht metallisierbaren Trägersubstrates aktiviert werden, an denen durch nachfolgende Metallisierung eine Metallschicht zur Bildung der gewünschten Leiterbahnen aufgebracht wird.

Während das 2-Komponenten-Spritzgießverfahren überwiegend zur Erzeugung komplexer Strukturen mit hoher Dreidimensionalität angewandt wird, und insbesondere auch in Fällen, in denen Durchkontaktierungen, große Kontaktflächen oder Hinterschneidungen gefordert werden, findet die Laserstrahlaktivierung durch das Laser-Direkt-Strukturierungsverfahren überwiegend dann Anwendung, wenn sehr feine Leiterzüge oder feinverteilte Leitermuster benötigt werden.

Die vorliegende Erfindung hat sich zur Aufgabe gestellt, Maßnahmen vorzuschlagen, die eine relativ einfache Realisierung von Leiterträgern mit sowohl komplexen als auch feingliedrigen Leiterstrukturen ermöglichen.

Gelöst wird diese Aufgabe durch einen spritzgegossenen Leiterträger der eingangs genannten Art, der sich dadurch auszeichnet, dass das zweite Trägersubstrat aus einem nur auf laserstrahlaktivierten Bereichen metallisierbaren zweiten Kunststoffmaterial besteht, wobei sich über die beiden Trägersubstrate hinweg eine elektrische Leiteranordnung erstreckt, die aus einer auf den unabgedeckten Bereichen des ersten Trägersubstrates und auf den laserstrahlaktivierten Bereichen des zweiten Trägersubstrates befindlichen Metallisierung besteht.

Gelöst wird die Aufgabe ferner durch ein Herstellungsverfahren der eingangs genannten Art, das sich dadurch auszeichnet, dass ein ohne vorherige Laserstrahlaktivierung galvanisch metallisierbares erstes Kunststoffmaterial und ein nur auf laserstrahlaktivierten Bereichen galvanisch metallisierbares zweites Kunststoffmaterial durch Spritzgießen so aneinander angeformt werden, dass ein Substratkörper entsteht, der ein aus dem ersten Kunststoffmaterial bestehendes erstes Trägersubstrat und ein aus dem zweiten Kunststoffmaterial bestehendes, das erste Trägersubstrat partiell abdeckendes zweites Trägersubstrat enthält, wonach auf dem zweiten Trägersubstrat durch Laserstrahlaktivierung mittels eines über die Oberfläche des zweiten Trägersubstrates hinweg bewegten Laserstrahls ein Metallisierungsmuster erzeugt wird, das sich zumindest teilweise an einen oder mehrere unabgedeckte Bereiche des ersten Trägersubstrates anschließt, und wonach gleichzeitig auf dem Metallisierungsmuster und den unabgedeckten Bereichen galvanisch eine als elektrische Leiteranordnung verwendbare Metallisierung abgeschieden wird.

Die Erfindung basiert also auf dem an sich bekannten 2-Komponenten-Spritzgießverfahren, wobei allerdings als Material für das zweite Trägersubstrat ein nicht metallisierbares Kunststoffmaterial verwendet wird, dessen Aufbau eine Laserstrahlaktivierung zulässt. Auf diese Weise lässt sich ein Leiterträger realisieren, der über metallisierbare Bereiche verfügt, die aus den unabgedeckten Bereichen des ersten Trägersubstrates und von den nach dem Spritzgießen durch Laserstrahlbehandlung aktivierten Bereichen des zweiten Trägersubstrates bestehen. Folglich lassen sich auf einem die beiden Trägersubstrate enthaltenden Substratkörper sowohl relativ komplexe, eine hohe Dreidimensionalität aufweisende Metallisierungsbereiche als auch sehr feingliedrige und dünne Metallisierungsbereiche herstellen, die an einem oder mehreren Stellen miteinander verbunden sind. Beim nachfolgenden Metallisieren, was durch eine Galvanikbehandlung erfolgt, wird eine Metallisierung auf den Metallisierungsbereichen abgeschieden, deren Gestaltung den durch die Metallisierungsbereiche definierten Vorgaben entspricht. Somit lassen sich Leiterträger herstellen, die über ein sehr variables Layout verfügen, das jedoch mit sehr hoher Präzision gefertigt werden kann.

Für das erste Trägersubstrat wird zweckmäßigerweise ein erstes Kunststoffmaterial der Spezifikation PA66-GF, PC/ABS oder LCP (Vectra E820i-Pd) verwendet, während sich für das zweite Trägersubstrat Kunststoffmaterial der Bezeichnung PA6/6TMID, PBTMID oder PPMID empfiehlt, das von der Firma LPKF Laser & Electronics AG, 30827 Garbsen, Deutschland, vertrieben wird.

Nachfolgend wird die Erfindung anhand der beiliegenden Zeichnung näher erläutert. In dieser zeigen:
- Figur 1: einen nach dem erfindungsgemäßen Verfahren hergestellten Leiterträger in einer von vielen möglichen gestalterischen Konfigurationen,
- Figur 2: das nach einem ersten Spritzgießvorgang erzeugte erste Trägersubstrat des Leiterträgers gemäß Figur 1 und
- Figur 3: eine Verfahrensstufe, bei der das zweite Trägersubstrat durch Spritzgießen an das erste Trägersubstrat angeformt ist und wobei gerade durch Laser-Direkt-Strukturierung mittels eines Laserstrahls ein gestrichelt angedeutetes Metallisierungsmuster auf dem zweiten Trägersubstrat erzeugt wird.

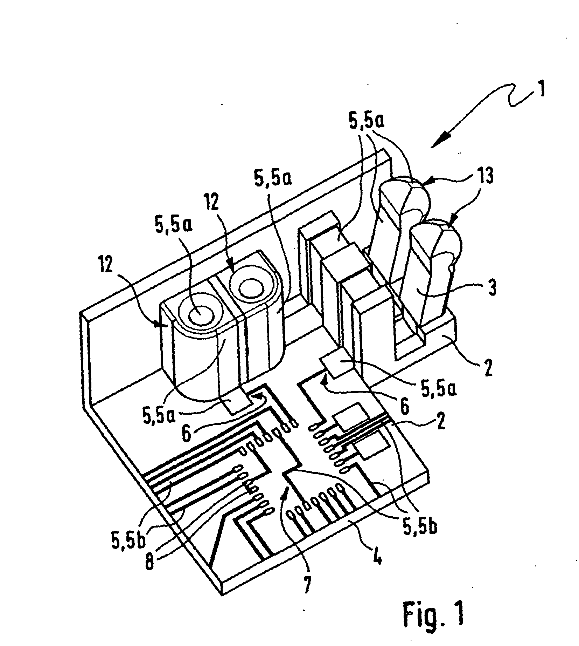

Die Figur 1 zeigt einen mit Bezugsziffer 1 versehenen erfindungsgemäßen Leiterträger, der unter Anwendung des erfindungsgemäßen Herstellungsverfahrens gefertigt worden ist. Der spritzgegossene Leiterträger 1 ist als dreidimensionales MID-Teil konzipiert. Er enthält einen aus wenigstens zwei unterschiedlichen Kunststoffmaterialien bestehenden Substratkörper 2, der sich aus einem ersten Trägersubstrat 3 und einem durch Spritzgießen daran angeformten zweiten Trägersubstrat 4 zusammensetzt.

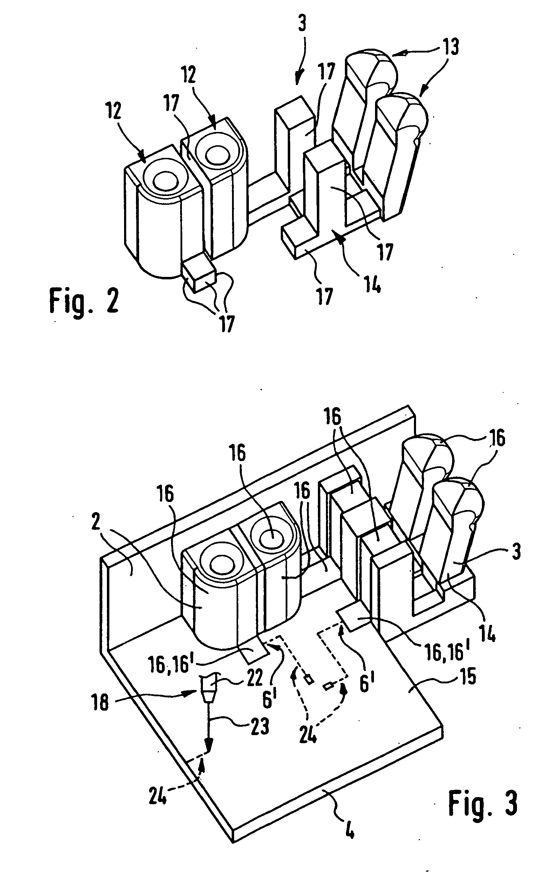

Die Figur 2 zeigt das erste Trägersubstrat 3 nach seiner Spritzgießherstellung. Dieses erste Trägersubstrat 3 wird zweckmäßigerweise zeitlich vor dem zweiten Trägersubstrat 4 gefertigt. Im Anschluss an die Spritzgießherstellung des ersten Trägersubstrates 3 wird das zweite Trägersubstrat 4 in einer gewünschten Weise durch Spritzgießen an das erste Trägersubstrat 3 angeformt. Da beide Trägersubstrate 3, 4 aus Kunststoffmaterial bestehen, stellt der Substratkörper 2 somit ein 2-Komponenten-Spritzgussteil dar.

Der Substratkörper 2 ist an seiner Oberfläche mit einer elektrischen Leiteranordnung 5 beschichtet. Sie besteht aus einer Metallisierung, die galvanisch auf vorbestimmten Bereichen des Substratkörpers 2 abgeschieden wurde. Erste Komponenten 5a der elektrischen Leiteranordnung 5 erstrecken sich auf dem ersten Trägersubstrat 3. Zweite Komponenten 5b der elektrischen Leiteranordnung 5 verlaufen auf der Oberfläche des zweiten Trägersubstrates 4. An einer oder mehreren Übergangsstellen 6 stehen zumindest einige der ersten und zweiten Komponenten 5a, 5b miteinander in elektrischer Verbindung, da hier eine ununterbrochene Metallisierung vorliegt.

Die auf dem zweiten Trägersubstrat 4 ausgebildeten zweiten Komponenten 5b der elektrischen Leiteranordnung 5 können wie abgebildet eine Feinleiterstruktur darstellen. Sie setzt sich aus einer oder mehreren relativ dünnen Leiterzügen zusammen, wobei Breitenabmessungen der einzelnen Leiterzüge von unter 100 µm realisierbar sind. Die Leiteranordnung 5 kann auf dem zweiten Trägersubstrat 4 wie abgebildet eine Anschlusszone 7 definieren, an der mehrere Leiterbahnen mit von der Metallisierung definierten Anschlusspads 8 enden, an denen eine elektronische Komponente, beispielsweise ein Chip, kontaktiert und fixiert werden kann. Auf diese Weise lässt sich problemlos eine elektronische Schaltung realisieren.

Während die zweiten Komponenten 5b der Leiteranordnung 5 überwiegend eine lediglich zweidimensionale oder nur gering dreidimensionale Struktur aufweisen, können die ersten Komponenten 5a über eine sehr komplexe und auch relativ hohe dreidimensionale Strukturierung verfügen. Sie befinden sich hier beispielsweise an der Oberfläche einer oder mehrerer Anschlussbuchsen 12 oder eines oder mehrerer Federkontakte 13, die durch entsprechende Formgebung vom ersten Trägersubstrat 3 definiert werden. Anstelle der Anschlussbuchsen 12 könnten auch andere Anschlusskomponenten vorgesehen sein. Auch könnte sich die elektrische Leiteranordnung am ersten Trägersubstrat 3 beispielsweise an Schirmungsbereichen oder Durchkontaktierungen befinden.

Nun zur bevorzugten Herstellung des spritzgegossenen Leiterträgers 1.

Bei der Herstellung wird zunächst aus einem ersten Kunststoffmaterial 14 durch Spritzgießen das erste Trägersubstrat 3 hergestellt. Die Formgebung des ersten Trägersubstrates 3 orientiert sich am gewünschten Aufbau des Leiterträgers 1, der wiederum vom Einsatzzweck abhängt. Beispielsweise kann der Leiterträger 1 Bestandteil einer elektronischen Steuerung oder eines Sensors sein, doch sind auch alle anderen Anwendungsfelder offen, beispielsweise als Komponenten elektronischer Schaltungen in der Kommunikationstechnik oder der Automatisierungstechnik.

Das durch Spritzgießen herstellte erste Trägersubstrat 3 verfügt unter anderem über die noch unbeschichteten Anschlussbuchsen 12 und Federkontakte 13.

Das erste Kunststoffmaterial 14, aus dem das erste Trägersubstrat 3 hergestellt wird, ist galvanisch metallisierbar. Es ist also geeignet, um mit den üblichen galvanischen Metallisierungstechniken, wie sie beispielsweise in der EP 0782765 B1 beschrieben werden, ganzflächig metallisiert zu werden.

Als Kunststoffmaterial empfiehlt sich insbesondere Kunststoff mit der Bezeichnung PA66-GF, PC/ABS oder LCP (Vectra E820i-Pd).

An das durch Spritzgießen hergestellte erste Trägersubstrat 3 wird in einem darauffolgenden Spritzgießvorgang ein zweites Kunststoffmaterial 15 angeformt, das im ausgehärteten Zustand das zweite Trägersubstrat 4 bildet. Es liegt dann der aus Figur 3 ersichtliche Substratkörper 2 vor, der sich aus den beiden Kunststoffkomponenten 14, 15 bzw. den beiden Trägersubstraten 3, 4 zusammensetzt. Der Substratkörper 2 ist eine starre Baueinheit.

Das Anspritzen des zweiten Kunststoffmaterials 15 an das erste Trägersubstrat 3 geschieht in einer Weise, dass vorbestimmte Bereiche des ersten Trägersubstrates 3 von dem zweiten Kunststoffmaterial 15 abgedeckt werden und wiederum andere Bereiche unabgedeckt bleiben. Verschiedene unabgedeckte Bereiche sind in Figur 3 mit der Bezugsziffer 16 identifiziert. Solche Bereiche, die durch das angeformte zweite Kunststoffmaterial 15 abgedeckt werden, sind in Figur 2 bei 17 exemplarisch angedeutet.

Das selektive Freilassen und Abdecken bestimmter Bereiche des ersten Trägersubstrates 3 geschieht durch entsprechende Gestaltung der Gießform, in der das zweite Kunststoffmaterial 15 an das erste Kunststoffmaterial 14 bzw. das erste Trägersubstrat 3 angeformt wird.

Das zweite Kunststoffmaterial 15 ist so ausgebildet, dass es grundsätzlich nicht metallisierbar ist. Es kann also mit den üblichen Schritten, die beispielsweise in der EP 0782765 B1 beschrieben werden, nicht metallisiert werden.

Das zweite Kunststoffmaterial 15 verfügt jedoch vorteilhafterweise noch über die weitere Eigenschaft, laserstrahlaktivierbar zu sein. Auf Basis dieser Materialeigenschaft wird das zweite Trägersubstrat 4 nach der Spritzgießfertigung des Substratkörpers 2 an der Oberfläche in ausgewählten Bereichen einer Laser-Direkt-Strukturierung unterzogen. Eine Momentaufnahme dieses Aktivierungsvorganges ist in Figur 3 bei 18 angedeutet. Man erkennt dort einen Laser 22, der mittels einer nicht näher gezeigten maschinellen Positioniervorrichtung so über die Oberfläche des zweiten Trägersubstrates 4 hinweg bewegt wird, dass sein Laserstrahl 23 auf der Oberfläche des zweiten Trägersubstrates 4 ein strichpunktiert angedeutetes Metallisierungsmuster 24 erzeugt.

Das zweite Kunststoffmaterial ist beispielsweise ein für MID-Einsätze optimierter PBT-Kunststoff (Polybutylenterephtalat), wobei das Kunststoffmaterial mit eingebetteten laseraktivierbaren Metallpartikeln bzw. Metallkeimen - beispielsweise aus Palladium oder Kupfer - versehen ist. Es handelt sich dabei beispielsweise um Kunststoffmaterial der Bezeichnung PA6/6TMID, PBTMID oder PPMID, das von der Firma LPKF Laser & Electronics AG, 30827 Garbsen, Deutschland, vertrieben wird. Weitere Materialien sind in Vorbereitung.

Durch den über die Oberfläche des zweiten Trägersubstrates 4 hinweggeführten Laserstrahl erfolgt eine lokale Aktivierung der Substratoberfläche, durch die das gewünschte Schaltungs-Layout erzeugt wird. In den bestrahlten Oberflächenbereichen findet eine lokale Materialaktivierung statt. Zum einen werden aus speziellen, nichtleitenden Wirksubstanzen Metallkeime abgespalten oder die Metallkeimumhüllung aufgebrochen. Gleichzeitig können weitere Füllstoffe des Kunststoffmaterials eine ausgeprägte Rauhigkeit auf den bestrahlten Oberflächenbereichen erzeugen. Dadurch werden auf dem von Hause aus nicht metallisierbaren zweiten Trägersubstrat entsprechend aktivierte Metallisierungsmuster 24 erzeugt, auf denen nun bei einem sich anschließenden galvanischen Metallisierungsprozess eine Metallisierung erfolgen kann. Im Bereich der abgespaltenen und teilweise freigelegten Metallkeime findet beispielsweise eine lokale, der Laserspur folgende Kupfermetallisierung statt, wobei durch die Rauhigkeit eine sehr gute Haftung für die im Galvanikbad entstehende Metallschicht gewährleistet wird.

Nach der bereichweisen Laseraktivierung des zweiten Trägersubstrates 4 liegt also ein Substratkörper 2 vor, der über mehrere galvanisch metallisierbare Oberflächenbereiche verfügt. Bei diesen galvanisch metallisierbaren Oberflächenbereichen handelt es sich zum einen um die unabgedeckten Bereiche 16 des ersten Trägersubstrates 3 und zum anderen um das durch Laser-Direkt-Strukturierung erzeugte Metallisierungsmuster 24.

Der Substratkörper 2 wird nun insgesamt einer galvanischen Behandlung unterzogen, wobei sich in den vorgenannten Zonen das im Galvanikbad enthaltene Metall, insbesondere Kupfer, abscheidet. Dadurch entsteht in den genannten Zonen eine durchgehende Metallisierung, die die elektrische Leiteranordnung 5 (Figur 1) bildet.

An den Übergangsstellen 6 war zuvor das Metallisierungsmuster 24 so ausgebildet worden, dass es sich an den entsprechenden Oberflächenbereichen 6' unmittelbar an einen unabgedeckten Bereich 16 des ersten Trägersubstrates 3 anschließt. Dadurch wird eine ununterbrochene, durchgehende Metallisierung an den Übergangsstellen 6 gewährleistet.

Zweckmäßigerweise zieht man als Ausgangspunkt für die Oberflächenbereiche 6' padartig großflächig ausgebildete unabgedeckte Bereiche 16' des ersten Trägersubstrates 3 heran. Es ist auf diese Weise möglich, eine sehr zuverlässige Verbindung zwischen dem Metallisierungsmuster 24 und den unabgedeckten Bereichen 16 herzustellen.

Es ist offensichtlich, dass durch das erfindungsgemäße Verfahren ein sehr variables Leiter-Layout hergestellt werden kann. Dabei können sowohl Strukturen höherer Dreidimensionalität als auch feine Leiterstrukturen auf ein und demselben Substratkörper 2 durch ein und dieselbe chemische Behandlung erzeugt werden. Das Verfahren ist somit sehr rationell ausführbar.

## Patentansprüche

1. Spritzgegossener Leiterträger, mit einem aus ohme vorherige Laserstrahlaktivierung galvanisch metallisierbarem erstem Kunststoffmaterial (14) bestehenden ersten Trägersubstrat (3), an das durch Spritzgießen ein zweites Trägersubstrat (4) so angeformt ist, dass das erste Trägersubstrat (3) partiell unabgedeckt bleibt, **dadurch gekennzeichnet, dass** das zweite Trägersubstrat (4) aus einem nur auf laserstrahlaktivierten Bereichen galvanisch metallisierbaren zweiten Kunststoffmaterial (15) besteht, wobei sich über die beiden Trägersubstrate (3, 4) hinweg eine elektrische Leiteranordnung (5) erstreckt, die aus einer auf den unabgedeckten Bereichen (16) des ersten Trägersubstrates (3) und auf den laserstrahlaktivierten Bereichen (24) des zweiten Trägersubstrates (4) befindlichen Metallisierung besteht.

2. Leiterträger nach Anspruch 1, **dadurch gekennzeichnet, dass** sich die Leiteranordnung (5) auf dem ersten Trägersubstrat (3) auf von integralen Bestandteilen des ersten Trägersubstrates (3) gebildeten Federelementen (13) oder Anschlusskomponenten (12) erstreckt.

3. Leiterträger nach Anspruch 1 oder 2, **dadurch gekennzeichnet, dass** die Leiteranordnung (5) auf dem zweiten Trägersubstrat (4) als Feinleiterstruktur ausgebildet ist

4. Leiterträger nach einem der Ansprüche 1 bis 3, **dadurch gekennzeichnet, dass** sich die laserstrahlaktivierten Bereiche (24) des zweiten Trägersubstrates (4) an padartig großflächig ausgebildete unabgedeckte Bereiche (16') des ersten Trägersubstrates (3) anschließen.

5. Leiterträger nach einem der Ansprüche 1 bis 4, **dadurch gekennzeichnet, dass** es sich bei dem ersten Kunststoffmaterial (14) um Material mit der Spezifikation PA66-GF, PC/ABS oder LCP (Vectra E820i-Pd) und bei dem zweiten Kunststoffmaterial (15) um Material mit der Spezifikation PA6/6TMID, PBTMID oder PPMID handelt.

6. Verfahren zur Herstellung eines spritzgegossenen Leiterträgers unter Anwendung eines 2-Komponenten-Spritzgießverfahrens, **dadurch gekennzeichnet, dass** ein ohne vorherige Laserstrahlaktivierung galvanisch metallisierbares erstes Kunststoffmaterial (14) und ein nur auf laserstrahlaktivierten Bereichen galvanisch metallisierbares zweites Kunststoffmaterial (15) durch Spritzgießen so aneinander angeformt werden, dass ein Substratkörper (2) entsteht, der ein aus dem ersten Kunststoffmaterial (14) bestehendes erstes Trägersubstrat (3) und ein aus dem zweiten Kunststoffmaterial (15) bestehendes, das erste Trägersubstrat (3) partiell abdeckendes zweites Trägersubstrat (4) enthält, wonach auf dem zweiten Trägersubstrat (4) durch Laserstrahlaktivierung mittels eines über die Oberfläche des zweiten Trägersubstrates (4) hinweg bewegten Laserstrahls (23) ein Metallisierungsmuster (24) erzeugt wird, das sich zumindest teilweise an einen oder mehrere unabgedeckte Bereiche (16, 16') des ersten Trägersubstrates (3) anschließt, und wonach gleichzeitig auf dem Metallisierungsmuster (24) und den unabgedeckten Bereichen (16, 16') galvanisch eine als elektrische Leiteranordnung (5) verwendbare Metallisierung abgeschieden wird.

7. Verfahren nach Anspruch 6, **dadurch gekennzeichnet, dass** man als erstes Kunststoffmaterial ein Material der Spezifikation PA66-GF, PC/ABS oder LCP (Vectra E820i Pd) und als zweites Kunststoffmaterial (15) ein Material mit der Spezifikation PA6/6TMID, PBTMID oder PPMID verwendet.

## Claims

1. Injection-moulded conductor carrier, with a first carrier substrate (3) consisting of a plastics material (14) galvanically metallisable without prior laser beam activation, onto which a second carrier substrate (4) is moulded by injection moulding in such a way that the first carrier substrate (3) remains partially uncovered, **characterised in that** the second carrier substrate (4) consists of a second plastics material (15) galvanically metallisable only on areas activated by laser beam, wherein an electrical conductor arrangement (5) extends over the two carrier substrates (3,4), which consists of a metallisation located on the uncovered areas (16) of the first carrier substrate (3) and on the laser beam-activated areas (24) of the second carrier substrate (4).

2. Conductor carrier according to Claim 1, **characterised in that** the conductor arrangement (5) on the first carrier substrate (3) extends on spring elements (13) or connection components (12) formed from integral constituent parts of the first carrier substrate (3).

3. Conductor carrier according to Claim 1 or 2, **characterised in that** the conductor arrangement (5) is formed on the second carrier substrate (4) as a fine conductor structure.

4. Conductor carrier according to any one of Claims 1 to 3, **characterised in that** the laser beam-activated areas (24) of the second carrier substrate (4) connect to uncovered areas (16') of the first carrier substrate (3), designed to be pad-like and of large surface area.

5. Conductor carrier according to one of Claims 1 to 4, **characterised in that** the first plastics material (14) is a material with the specification PA66-GF, PC/ABS or LCP (Vectra E820i-Pd) and the second plastics material (15) has the specification PA6/6TMID, PBTMID, or PPMID.

6. Method for the manufacture of an injection-moulded conductor carrier making use of a two-component injection-moulding process, **characterised in that** a first plastics material (14), galvanically metallisable without prior laser beam activation, and a second plastics material (15), only galvanically metallisable on laser beam-activated areas, are moulded to one another by injection moulding in such a way that a substrate body (2) is formed, which contains a first carrier substrate (3) consisting of the first plastics material (14) and a second carrier substrate (4) consisting of the second plastics material (15), partially covering the first carrier substrate (3), according to which a metallisation pattern (24) is created by laser beam activation by means of a laser beam (23) moved over the surface of the second carrier substrate (4), which metallization pattern (24) connects at least partially on one or more uncovered areas (16, 16') of the first carrier substrate (3), and according to which, at the same time, a metallisation is galvanically deposited on the metallisation pattern (24) and the uncovered areas (16, 16'), which can be used as an electrical conductor arrangement (5).

7. Method according to Claim 6, **characterised in that** the first plastics material (14) is a material with the specification PA66-GF, PC/ABS or LCP (Vectra E820i-Pd) and the second plastics material (15) has the specification PA6/6TMID, PBTMID, or PPMID.

## Revendications

1. Support de circuit imprimé moulé par injection, avec un premier substrat de support (3) composé d'une première matière plastique métallisable par galvanisation (14), sans activation au laser préalable, substrat sur lequel un deuxième substrat de support (4) est rapporté par moulage par injection de telle sorte que le premier substrat de support (3) reste en partie à découvert, **caractérisé en ce que** le deuxième substrat de support (4) se compose d'une deuxième matière plastique (15) métallisable par galvanisation uniquement dans des zones activées au laser, un ensemble de conducteurs électriques (5) s'étendant à travers les deux substrats de support (3, 4) qui se compose d'une métallisation se trouvant dans les zones à découvert (16) du premier substrat de support (3) et dans les zones activées au laser (24) du deuxième substrat de support (4).

2. Support de circuit imprimé selon la revendication 1, **caractérisé en ce que** l'ensemble de conducteurs (5) s'étend sur le premier substrat de support (3) sur des éléments formant ressort (13) ou des composants de connexion (12) formés par des composants intégrés du premier substrat de support (3).

3. Support de circuit imprimé selon la revendication 1 ou 2, **caractérisé en ce que** l'ensemble de conducteurs (5) est réalisé sur le deuxième substrat de support (4) comme une structure de conducteurs fins.

4. Support de circuit imprimé selon l'une des revendications 1 à 3, **caractérisé en ce que** les zones activées au laser (24) du deuxième substrat de support (4) sont adjacentes à des zones à découvert (16') réalisées sur une grande surface, à la manière d'une plage de contact, du premier substrat de support (3).

5. Support de circuit imprimé selon l'une des revendications 1 à 4, **caractérisé en ce que** la première matière plastique (14) est une matière de la spécification PA66-GF, PC/ABS ou LCP (Vectra E820i-Pd) et **en ce que** la deuxième matière plastique (15) est une matière de la spécification PA6/6TMID, PBTMID ou PPMID.

6. Procédé de fabrication d'un support de circuit imprimé moulé par injection en utilisant un procédé de moulage par injection à deux composants, **caractérisé en ce qu'**une première matière plastique (14) métallisable par galvanisation, sans activation au laser préalable, et une deuxième matière plastique (15) métallisable par galvanisation uniquement dans des zones activées au laser sont rapportées l'une à l'autre par moulage par injection de telle sorte qu'un corps de substrat (2) est créé qui comprend un premier substrat de support (3) composé de la première matière plastique (14) et un deuxième substrat de support (4) composé de la deuxième matière plastique (15) et recouvrant partiellement le premier substrat de support (3), après quoi, sur le deuxième substrat de support (4), un motif de métallisation (24) est généré par activation au laser au moyen d'un faisceau laser (23) déplacé sur la surface du deuxième substrat de support (4), le motif étant adjacent au moins en partie à une ou plusieurs zones à découvert (16, 16') du premier substrat de support (3), et après quoi, une métallisation utilisable en tant qu'ensemble de conducteurs électriques (5) est déposée par galvanisation en même temps sur le motif de métallisation (24) et les zones à découvert (16, 16').

7. Procédé selon la revendication 6, **caractérisé en ce que** l'on utilise comme première matière plastique une matière de la spécification PA66-GF, PC/ABS ou LCP (Vectra E820i Pd) et comme deuxième matière plastique (15) une matière de la spécification PA6/6TMID, PBTMID ou PPMID.
